# EUROPÄISCHE PATENTSCHRIFT

(11) **EP 1 192 845 B1**
(45) Veröffentlichungstag und Bekanntmachung des Hinweises auf die Patenterteilung: **15.10.2008**
(21) Anmeldenummer: 00945697.1
(22) Anmeldetag: 02.06.2000
(51) Int. Cl.: H05K 7/20, B01D 46/42, F24F 13/28

(54) **FILTERLÜFTER, DER IN EINER AUSNEHMUNG EINER WAND MONTIERBAR IST**
FILTER-FAN THAT CAN BE FITTED IN A WALL RECESS
VENTILATEUR A FILTRE POUVANT ETRE MONTE DANS UN EVIDEMENT DE PAROI

(30) Priorität: 02.06.1999 DE 19925439
(43) Veröffentlichungstag der Anmeldung: 03.04.2002
(73) Patentinhaber: STEGO-Holding GmbH, 74523 Schwäbisch Hall (DE)
(72) Erfinder: EISENHAUER, Hartmut, D-74545 Michelfeld (DE)
(74) Vertreter: Bohnenberger, Johannes
(86) Internationale Anmeldenummer: PCT/EP2000/005057
(87) Internationale Veröffentlichungsnummer: WO 2000/074459

(56) Entgegenhaltungen:
- DE-A- 19 700 065
- DE-C- 19 525 850
- DE-U- 9 306 032

## Beschreibung

Die Erfindung betrifft einen Filterlüfter gemäß dem Oberbegriff des Patentanspruches 1.

Filterlüfter werden zur Belüftung von Schaltschränken, Schaltungsgehäusen, Gerätegehäusen oder dergleichen benötigt. Insbesondere elektronische Baugruppen, die in Schaltschränken integriert sind, verursachen eine starke Wärmeentwicklung. Bei Überhitzung können elektronische Bauelemente, insbesondere Halbleiterbauelemente beschädigt oder sogar zerstört werden. Eine Belüftung der Schaltschränke wirkt einer allzu großen Wärmeentwicklung entgegen. Dazu wird mittels eines Lüfters Außenluft angesaugt und in das Schaltschrankinnere hineingeblasen. Über eine oder mehrere Ausblasöffnungen, die in den Wänden der Schaltschränke ausgebildet sind, wird die erwärmte Luft wieder nach außen geblasen. Somit findet ein Wärmeaustausch zwischen der Luft im Schaltschrank und der Außenluft statt.

In der Außenluft sind stets Staubpartikel vorhanden. Oftmals ist es erforderlich, dass die Schaltschränke in einer besonders staubigen Umgebung aufgestellt werden müssen. Zweckmäßigerweise ist deshalb dem Lüfter ein Filter vorgeschaltet. Somit durchläuft die angesaugte Luft zunächst den Filter, anschließend den Lüfter und gelangt dann in den Schaltschrank. Die im Schaltschrankinneren erwärmte Luft wird über die Ausblasöffnungen wieder nach außen abgeführt. Üblicherweise sind die Filterlüfter in ausgestanzte oder ausgenibbelte Öffnungen der Schaltschrankwand eingesetzt.

Die Filter müssen insbesondere bei staubiger Umgebung relativ häufig ausgetauscht werden. Die Lüftermotoren haben zwar eine relativ hohe Lebensdauer, aber bei Dauerbetrieb muss ebenfalls mit einem Ausfall des Motors gerechnet werden, so daß auch die Lüftermotoren ausgewechselt werden müssen.

Bei den bekannten Filterlüftern ist das Auswechseln des Lüftermotors relativ aufwendig. Der Lüftermotor befindet sich im Inneren des Schaltschranks und ist nur von dort aus zugänglich, während die Befestigungsmittel für den Lüftermotor nur von außen zugänglich sind. Somit sind zum Auswechseln der Lüftermotoren zwei Personen erforderlich. Die eine Person bedient von außen die Befestigungsmittel, während die andere Person den Motor von innen hält. Dieser Vorgang ist sehr aufwendig. Außerdem kann es aus Sicherheitsgründen erforderlich sein, daß die elektronischen Baugruppen abgeschaltet werden müssen, bevor eine Person in das Innere des Schaltschrankes greift.

Auch die erstmalige Montage der bekannten Filterlüfter in die Ausnehmung einer Wand ist verhältnismäßig aufwendig. Dazu sind wieder wenigstens zwei Personen erforderlich, die von zwei Seiten der Wand aus die Montage durchführen.

Weiterhin ist es erwünscht, daß die Schaltschränke gegen die Ein- und Ausstrahlung elektromagnetischer Wellen abgedichtet sind. Eine derartige EMV-Abschirmung ist bei gleichzeitiger Belüftung des Schaltschrankes schwierig. Es sind EMV-abgeschirmte Lüfter bekannt, bei denen zwischen dem Filter und dem Lüftermotor Gitter angeordnet sind. Diese Gitter sind über Blechstreifen mit Kontaktblechen verbunden, welche an der Rückseite von Befestigungsflanschen für die Lüfter angebracht sind. Eine derartige Abschirmung weist EMV-undichte Bereiche auf und wird den Anforderungen häufig nicht gerecht. Für eine optimale EMV-Abschirmung ist es erforderlich, daß der gesamte Umfang einer Ausnehmung in der Schaltschrankwand mit dem Gitter elektrisch verbunden ist. Dazu muß bei den bekannten Vorrichtungen die Schrankschaltwand um die Ausnehmung herum blank sein. Da eine Schrankschaltwand im allgemeinen lackiert ist, muß sie vor dem Einbau eines Lüfters vom Lack befreit werden. Bei den bekannten Lüftern ist dies an der Innenseite der Schaltschrankwand erforderlich. Sowohl die Erstmontage der Lüfter als auch das Auswechseln der Lüftermotoren oder Filter ist sehr aufwendig.

Aus der DE-A 197 00 065 ist ein Filterlüfter nach dem Oberbegriff des Patentanspruches 1 bekannt. Bei diesem Filterlüfter ist der Lüftermotor am Einbaurahmen und zwar auf dessen hinterer, dem Filter gegenüberliegenden Seite derart befestigt, dass der Lüftermotor bei Einbau in die Wand eines Schaltschranks in den Schaltschrank ragt. Muss der Lüftermotor zu Wartungs- oder Reparaturzwecken ausgebaut werden, so ist dies sehr umständlich.

Der Erfindung liegt die Aufgabe zugrunde, einen Filterlüfter bereitzustellen, der auf einfache Weise montierbar und demontierbar ist und bei dem der Lüftermotor und der Filter von einer Seite der Wand aus durch eine einzige Person ausgewechselt werden können.

Für den Filterlüfter wird diese Aufgabe durch den Gegenstand gemäß den Merkmalen des Patentanspruches 1 gelöst.

Gemäß der Erfindung sind für den Filterlüfter ein Einbaurahmen und ein Einsetzrahmen vorgesehen, wobei der Einbaurahmen Befestigungsmittel aufweist und in der Ausnehmung dauerhaft befestigbar ist, der Einsetzrahmen lösbar im Einbaurahmen eingesetzt ist, der Lüftermotor mit dem Einsetzrahmen lösbar verbunden ist und der Filter im Einsetzrahmen lösbar eingesetzt ist.

Bei der erstmaligen Montage des Filterlüfters in die Ausnehmung einer Wand ist somit vorgesehen, dass der Einbaurahmen durch Befestigungsmittel in der Ausnehmung der Wand dauerhaft befestigt wird. Der Einsetzrahmen ist lösbar im Einbaurahmen eingesetzt und muss nur dann aus dem Einbaurahmen herausgenommen werden, wenn ein Zugang zur abgewandten Seite des Lüftermotors oder ein Auswechseln des Lüftermotors erforderlich ist. Der Filter ist lediglich im Einsetzrahmen aus der Sicht des Bedieners vor dem Lüftermotor lösbar eingesetzt, so dass beim Auswechseln des Filters der Einsetzrahmen im Einbaurahmen verbleiben kann. Der erstmalige Einbau des Filterlüfters in die Ausnehmung einer Wand, das Auswechseln des Filters und das Auswechseln des Lüftermotors kann somit von einer einzigen Person und von einer einzigen Seite der Wand aus, insbesondere von der Außenseite der Wand aus vorgenommen werden. Es kann ein handelsüblicher Lüftermotor verwendet werden, der vor Ort erhältlich ist.

Vorzugsweise ist vorgesehen, daß sich im Einsetzrahmen parallel zur Rahmenebene ein Gitter erstreckt, das zwischen dem Lüftermotor und dem Filter angeordnet ist. Durch dieses Gitter wird die räumliche Trennung des Filters vom Lüftermotor, insbesondere zu den Gebläseflügeln gewährleistet. Ein Eindringen von Filterpartikeln in den Lüftermotor wird dadurch unterbunden oder zumindest eingeschränkt.

Vorzugsweise ist vorgesehen, daß der Einsetzrahmen mit dem Gitter einstückig ausgebildet ist. Dies trägt zur Stabilität des Einsetzrahmens bei. Ein derartiger Einsetzrahmen ist einfach und kostengünstig herstellbar.

Weiterhin kann vorgesehen sein, daß der Einsetzrahmen erste Distanzelemente aufweist, so daß ein vorbestimmter Abstand zwischen dem Gitter und dem Filter ausgebildet ist. Auf diese Weise ist zwischen dem Gitter und dem Filter ein Hohlraum ausgebildet, der als Druckausgleichs- oder Verwirbelungsraum wirkt. Dadurch strömt die Luft gleichmäßig durch den Filter, was einen geringen Druckverlust und eine optimale Ausnutzung des Filters zur Folge hat.

Ebenso kann vorgesehen sein, daß der Einsetzrahmen zweite Distanzelemente aufweist, so daß ein vorbestimmter Abstand zwischen dem Gitter und dem Lüftermotor ausgebildet ist. Auch der dadurch gebildete Hohlraum bewirkt einen verhältnismäßig geringen Druckverlust des Luftstromes.

Bei einer besonders bevorzugten Ausführungsform der Erfindung ist vorgesehen, daß der Einbaurahmen, der Einsetzrahmen und das Gitter aus Metall hergestellt sind oder zumindest deren Oberflächen eine Metallbeschichtung aufweisen. Durch diese Maßnahmen läßt sich der Filterlüfter EMV-dicht ausbilden. Für viele Schaltschränke oder dergleichen ist es erforderlich oder zumindest erwünscht, daß durch deren Wände keine elektromagnetische Strahlung ein- oder ausdringt. In dieser Hinsicht bildet die Ausnehmung eine Schwachstelle, die insbesondere durch das metallene oder metallisierte Gitter behoben wird. Auf diese Weise läßt sich der Schaltschrank belüften und gleichzeitig die erforderliche EMV-Dichtigkeit erreichen.

Weiterhin ist vorgesehen, daß der Einsetzrahmen im Einbaurahmen mittels einer Klemmvorrichtung lösbar befestigt ist. Zum Lösen einer Klemmvorrichtung sind im allgemeinen keine oder nur einfache Standardwerkzeuge erforderlich, so daß der Einsetzrahmen aus dem Einbaurahmen auf schnelle und einfache Weise entfernt und wieder eingesetzt werden kann.

Insbesondere ist vorgesehen, daß die Klemmvorrichtung durch eine Vielzahl Federzungen gebildet ist. Vorzugsweise sind die Federzungen am Umfang des Einsetzrahmens angeordnet und erstrekken sich senkrecht zur Rahmenebene. Die Federzungen gewährleisten einen sicheren Halt des Einsetzrahmens im Einbaurahmen. Weiterhin wird durch die Federzungen eine durchgehende elektrische Verbindung zwischen Einsetzrahmen und Einbaurahmen über den gesamten Umfang bereitgestellt. Dies trägt wesentlich zur EMV-Dichtigkeit bei.

Weiterhin ist vorgesehen, daß der Einbaurahmen einen Flansch aufweist, an dem die Befestigungsmittel angebracht sind. Ein Flansch ermöglicht ein besonders einfaches Einbauen des Einbaurahmens in die Ausnehmung der Wand und gewährleistet einen sicheren Halt. Weiterhin trägt der Flansch wesentlich zur EMV-Dichtigkeit bei.

Vorzugsweise ist vorgesehen, daß die Befestigungsmittel Klebestreifen sind. Die Klebestreifen ermöglichen eine besonders einfache Montage des Einbaurahmens in der Ausnehmung der Wand und bieten einen sicheren Halt. Außerdem sind damit keine Bohrlöcher in der Wand erforderlich. Weiterhin ist durch die Klebestreifen eine wasserdichte, zumindest spritzwasserfeste Verbindung bereitgestellt.

Weiterhin ist vorgesehen, daß der Einbaurahmen ein Kontaktband mit Zähnen umfaßt, das sich entlang des Umfangs des Einbaurahmens so erstreckt, daß die Zähne mit dem Rand der Ausnehmung in Eingriff bringbar sind. Dadurch wird eine elektrische Verbindung zwischen der Wand und dem Einbaurahmen über den gesamten Umfang des Einbaurahmens bzw. der Ausnehmung gewährleistet. Damit trägt das Kontaktband wesentlich zur EMV-Dichtigkeit bei. Weiterhin wird durch das Kontaktband der erstmalige Einbau des Filterlüfters in die Wand wesentlich erleichtert. Eine Entfernung des Lacks von der Wand des Schaltschranks, wie beim Stand der Technik, ist aufgrund der Zähne am Kontaktband nicht erforderlich. Das Kontaktband mit Zähnen, die beispielsweise aus Kupferberillium sind, ist handelsüblich. Die Zähne schneiden sich in den durch das Ausnibbeln oder Ausschneiden blanken Rand der Ausnehmung und liegen dort an. Durch das Kontaktband wird somit ein optimaler elektrischer Kontakt zwischen der Wand und dem Einbaurahmen bereitgestellt.

Für den Lüftermotor ist vorgesehen, daß er mittels Schrauben am Einsetzrahmen befestigt ist. Durch diese Schraubverbindung werden ein hinreichend sicherer Halt gewährleistet und ein schnelles und einfaches Auswechseln des Lüftermotors ermöglicht.

Weiterhin ist vorgesehen, daß der Lüftermotor mittels selbstschneidender Schrauben am Einsetzrahmen befestigt ist, wobei die durch die Schrauben geschnittenen Innengewinde am Einsetzrahmen, insbesondere im Gitter, vorgesehen sind. Bei der Herstellung des Einsetzrahmens bzw. Gitters müssen somit keine Gewindebohrungen oder dergleichen bereitgestellt werden. Ebensowenig sind Schraubenmuttern oder dergleichen erforderlich.

Dadurch wird die Anzahl der Einzelteile des Filterlüfters gering gehalten. Dies trägt zu einer kostengünstigen Herstellung des Filterlüfters bei.

Bei einer besonders bevorzugten Ausführungsform des Filterlüfters ist vorgesehen, daß der Einsetzrahmen aus Spritzguß-Kunststoff hergestellt ist. Teile aus Spritzguß-Kunststoff sind auf einfache Weise und kostengünstig herstellbar und mit einer Metalloberfläche beschichtbar. Auf diese Weise läßt sich einfach und kostengünstig die elektrische Leitfähigkeit und damit die EMV-Dichtigkeit gewährleisten.

Weiterhin ist vorgesehen, daß der Filterlüfter eine Abdeckhaube aufweist, die am Einsetzrahmen lösbar befestigt ist, wobei der Filter zwischen Einsetzrahmen und Abdeckhaube angeordnet ist und die Abdeckhaube einen luftdurchlässigen Bereich aufweist. Die Abdeckhaube hat sowohl technische als auch ästhetische Funktionen. Für die Abdeckhaube ist vorzugsweise vorgesehen, daß der luftdurchlässige Bereich eine Mehrzahl Lamellen aufweist, die derart ausgerichtet sind, daß die angesaugte Luft durch den luftdurchlässigen Bereich in Aufwärtsrichtung strömt. Dadurch wird die Anzahl der angesaugten Staubpartikel minimiert und das Eindringen von Spritzwasser in das Innere des Filterlüfters weitgehend vermieden.

Für eine alternative Ausführungsform des erfindungsgemäßen Filterlüfters kann vorgesehen sein, daß der Einbaurahmen topfförmig ausgebildet ist, wobei der Topfbereich den Lüftermotor umschließt und wenigstens einen luftdurchlässigen Bereich aufweist. Durch den topfförmigen Einbaurahmen wird ein mögliches Herunterfallen des Lüftermotors in das Schaltschrankinnere bei Montagearbeiten verhindert. Ist der Einbaurahmen aus Metall hergestellt oder hat zumindest eine metallene Oberfläche, wird dadurch die EMV-Dichtigkeit des Filterlüfters zusätzlich erhöht. Außerdem wird dadurch eine Abschirmung zwischen dem Lüftermotor und dem Inneren des Schaltschranks erreicht. Vorzugsweise ist der luftdurchlässige Bereich des Topfbereiches durch ein weiteres Gitter gebildet. Ein Gitter ermöglicht einerseits einen hohen Luftdurchsatz und andererseits eine hohe EMV-Dichtigkeit.

Für den erfindungsgemäßen Austrittsfilter ist vorgesehen, daß der Austrittsfilter ebenso wie der oben beschriebene Filterlüfter ausgebildet ist, jedoch keinen Lüftermotor mit Gebläseflügeln aufweist. Durch ein einfaches Weglassen des Lüftermotors läßt sich anstelle des Filterlüfters ein Austrittsfilter bereitstellen. Dies ist herstellungstechnisch eine besonders einfache und kostengünstige Lösung. Der Austrittsfilter benötigt keine weiteren Teile.

Für eine weitere Ausführungsform des erfindungsgemäßen Filterlüfters kann vorgesehen sein, daß der Filterlüfter anstelle eines einzigen Lüftermotors mehrere nebeneinander angeordnete Lüftermotoren aufweist. Vorzugsweise sind diese matrixförmig angeordnet und als Axiallüfter ausgebildet. Diese Ausführungsform hat den Vorteil, daß sich der Filterlüfter sehr flach ausbilden läßt. Außerdem ist der Filterlüfter bei Ausfall eines Motors immer noch funktionsfähig.

Weitere Merkmale, Vorteile und besondere Ausführungsformen der Erfindung sind Gegenstand der Unteransprüche.

Die Erfindung wird nachfolgend anhand der beigefügten Zeichnungen näher erläutert. Es zeigen:
- Fig. 1: eine perspektivische Explosionsansicht einer ersten bevorzugten Ausführungsform eines erfindungsgemäßen Filterlüfters;
- Fig. 1a: einen Ausschnitt einer Perspektivansicht eines Einbaurahmens des Filterlüfters gemäß Fig. 1;
- Fig. 1b: einen Ausschnitt einer Perspektivansicht eines Einsetzrahmens des Filterlüfters gemäß Fig. 1;
- Fig. 2: eine Längsschnittansicht des Filterlüfters gemäß Fig. 1;
- Fig. 3: eine Längsschnittansicht des zusammengesetzten Lüfterfilters gemäß Fig. 2;
- Fig. 4: eine Längsschnittansicht einer zweiten Ausführungsform des erfindungsgemäßen Filterlüfters in zusammengesetzten Zustand;
- Fig. 5: eine Längsschnittansicht einer dritten Ausführungsform des erfindungsgemäßen Filterlüfters;
- Fig. 6: eine Längsschnittansicht einer vierten Ausführungsform des erfindungsgemäßen Filterlüfters;
- Fig. 7: eine Längsschnittansicht des zusammengesetzten Filterlüfters gemäß Fig. 6; und
- Fig. 8: eine Querschnittansicht entlang der Linie A-A gemäß Fig. 6.

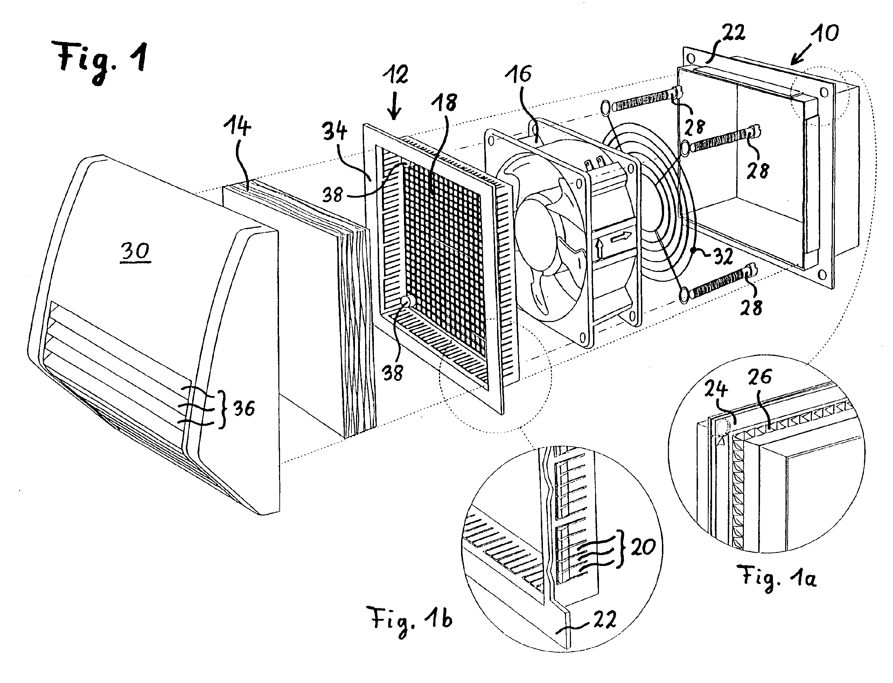

Fig. 1 zeigt eine perspektivische Explosionsansicht einer ersten bevorzugten Ausführungsform des erfindungsgemäßen Filterlüfters. Der Filterlüfter ist zum Einbau in eine Ausnehmung einer nicht dargestellten Wand vorgesehen. Der Filterlüfter weist einen Einbaurahmen 10, einen Einsetzrahmen 12, einen Filter 14, einen Lüftermotor 16 und eine Abdeckhaube 30 auf.

Der Einbaurahmen 10 ist als Rechteckrahmen ausgebildet und weist am äußeren Umfang einen Flansch 22 auf. An einer Seite des Flansches 22 sind Klebestreifen 24 angebracht. Unmittelbar neben den Klebestreifen 24 ist der Einbaurahmen 10 in Umfangsrichtung von einem Kontaktband 26 umgeben. Das Kontaktband 26 weist Zähne auf, die sich nach außen erstrecken. Fig. 1a zeigt einen Vergrößerungsausschnitt zur Verdeutlichung der Anordnung der Klebestreifen 24 und des Kontaktbandes 26.

Der Lüftermotor 16 weist Gebläseflügel auf, die ausgebildet sind, um einen Luftstrom parallel zur Drehachse des Motors zu erzeugen. Dem Lüftermotor 16 ist eine Mehrzahl Schrauben 28 zu dessen Befestigung am Einsetzrahmen 12 zugeordnet. Weiterhin ist dem Lüftermotor 16 ein Schutzgitter 32 zugeordnet. Ein derartiger Lüftermotor 16 ist handelsüblich.

Der Einsetzrahmen 12 weist an der einen Stirnseite einen Flansch 34 und an der anderen Stirnseite ein Gitter 18 auf. Der Flansch 34 erstreckt sich außerhalb des Einsetzrahmens 12 in dessen Umfangsrichtung. Das Gitter 18 erstreckt sich innerhalb des gesamten Einsetzrahmens 12 parallel zur Rahmenebene. Weiterhin weist der Einsetzrahmen 12 entlang seiner Umfangsfläche eine Vielzahl Federzungen 20 auf, die sich senkrecht zur Rahmenebene erstrecken. Durch die Federzungen 20 ist der Einsetzrahmen 10 nahezu spaltfrei im Einbaurahmen 12 eingesetzt. An der dem Filter 14 zugewandten Seite weist das Gitter 18 Distanzelemente 38 auf. An der dem Lüftermotor 16 zugewandten Seite des Gitters 18 sind ebenfalls Distanzelemente vorgesehen, die in dieser Darstellung nicht sichtbar sind. Der Einsetzrahmen 12 ist einstückig ausgebildet.

Fig. 1b zeigt einen Vergrößerungsausschnitt zur Verdeutlichung der Federzungen 20.

Der Filter 14 ist quaderförmig ausgebildet und sein Querschnitt ist geringfügig kleiner als der Innenquerschnitt des Einsetzrahmens 12. Der Filter 14 ist somit in den Einsetzrahmen 12 einsetzbar.

Die Abdeckhaube 30 ist mit dem Einsetzrahmen 12 zusammensteckbar, wobei der Filter 14 zwischen Abdeckhaube 30 und Einsetzrahmen 12 einklemmbar ist. Die Abdeckhaube 30 ist zur Anbringung an der Außenseite der nicht dargestellten Wand vorgesehen. Die Abdeckhaube 30 ist als einziges Teil des Filterlüfters von außerhalb der Wand sichtbar. Die Abdeckhaube 30 umfaßt einen luftdurchlässigen Bereich, der eine Mehrzahl Lamellen 36 aufweist. Die Lamellen 36 sind parallel zueinander angeordnet und so ausgerichtet, daß der Luftstrom in einem vorbestimmten Winkelbereich zur Drehachse des Lüftermotors 16 angesaugt wird. Es ist vorgesehen, die Abdeckhaube 30 so anzuordnen, daß der Luftstrom in Aufwärtsbewegung den luftdurchlässigen Bereich der Abdeckhaube 30 durchdringt. In diesem Fall sind die Lamellen 36 derart ausgerichtet, daß kaum Spritzwasser in den Filterlüfter eindringen kann.

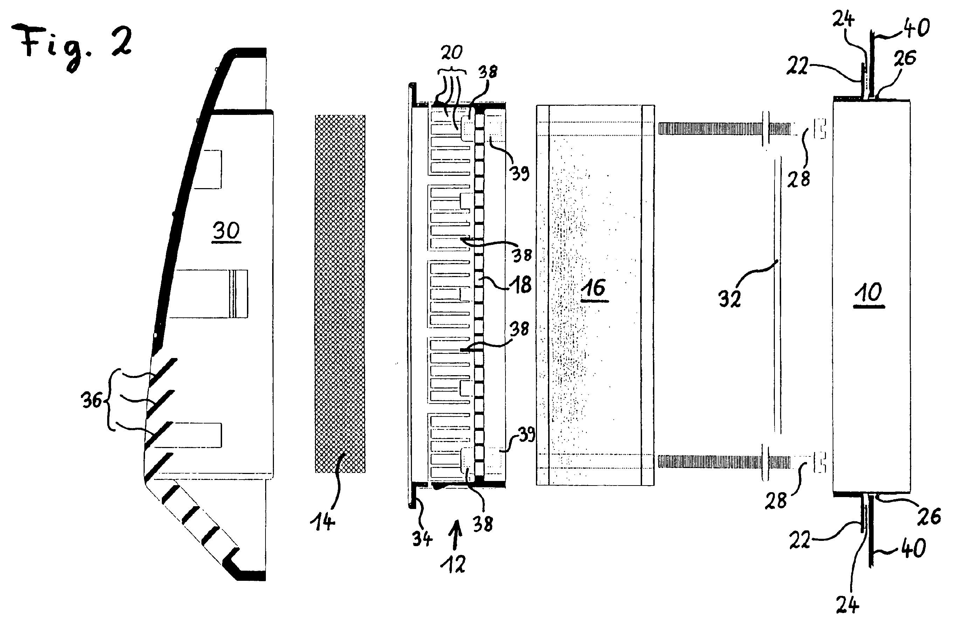

Fig. 2 zeigt eine Längsschnittansicht des Filterlüfters gemäß Fig. 1. In Fig. 2 ist die Aufnahme des Einbaurahmens 10 in einer Ausnehmung einer Wand 40 verdeutlicht. Der Einbaurahmen 10 ist am Randbereich um die Ausnehmung herum an der Außenseite der Wand 40 befestigt. Als Befestigungsmittel dienen die Klebestreifen 24, die am Flansch 22 des Einbaurahmens 10 angebracht sind.

Weiterhin verdeutlicht Fig. 2, wie der Lüftermotor 16 und der Einsetzrahmen 12 zusammensetzbar sind. Zusammen mit dem Schutzgitter 32 ist der Lüftermotor 16 am Einsetzgitter 12, und zwar an den Distanzelementen 39 mittels der Schrauben 28 montierbar. Die Schrauben 28 weisen ein selbstschneidendes Gewinde auf. Das Einsetzgitter 12 ist entweder aus Metall oder aus Spritzguß-Kunststoff hergestellt. Im letztgenannten Fall ist das aus Spritzguß-Kunststoff hergestellte Einsetzgitter 12 mit einer Metallschicht überzogen, damit das Einsetzgitter 12 elektrisch leitfähig ist und die gewünschte EMV-Dichtigkeit erreicht wird.

Das Abdeckgehäuse 30 und das Einsetzgitter 12 sind derart zusammensetzbar, daß der Filter 14 in den zwischen Abdeckgehäuse 30 und Einsetzgitter 12 gebildeten Hohlraum paßt. Für den Filter 14 sind somit keine weiteren Befestigungsmittel erforderlich.

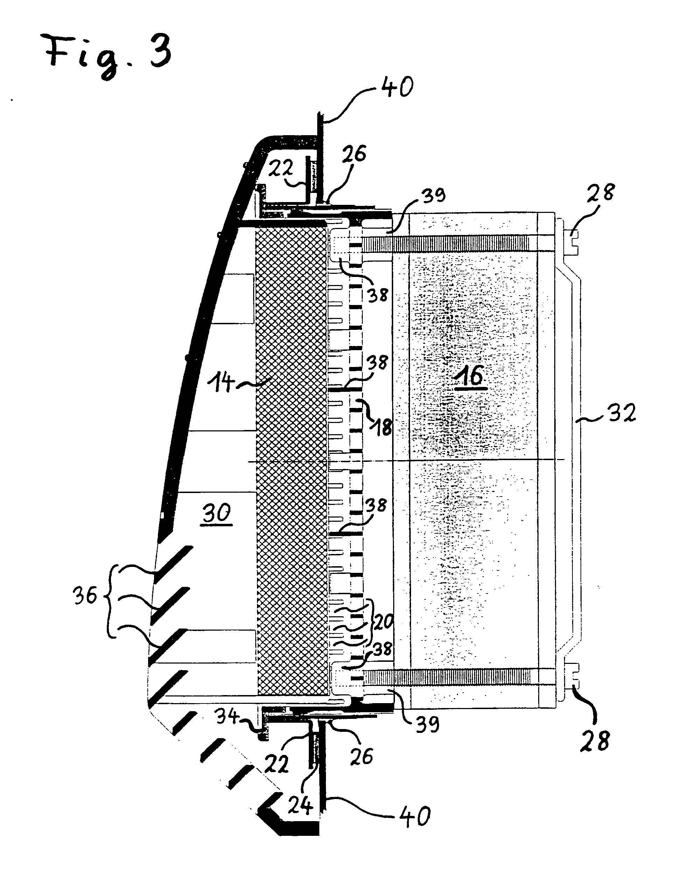

In Fig. 3 ist der Filterlüfter gemäß Fig. 2 im zusammengesetzten und eingebauten Zustand dargestellt. Fig. 3 gibt die tatsächliche Einbaulage des Lüfterfilters und seiner Bestandteile wieder. Fig. 3 verdeutlicht, daß von der Wand 40 über die Zähne des Kontaktbandes 26, den Einbaurahmen 10 und den Einsetzrahmen 12 zum Gitter 18 eine durchgehende elektrische Verbindung mit sehr kurzen Wegen besteht. Eine hohe EMV-Dichtigkeit ist somit gewährleistet. Durch die Distanzelemente 38 ist zwischen dem Gitter 18 und dem Filter 14 ein Hohlraum ausgebildet, der als Druckausgleichs- oder Verwirbelungsraum dient. Der Druckverlust des Luftstromes wird durch diesen Hohlraum gering gehalten. Das gleiche gilt für den Hohlraum, der durch die Distanzelemente 39 zwischen Gitter 14 und Lüftermotor 16 ausgebildet ist. Weiterhin verdeutlicht Fig. 3 die sehr kompakte Bauweise des gesamten Filterlüfters.

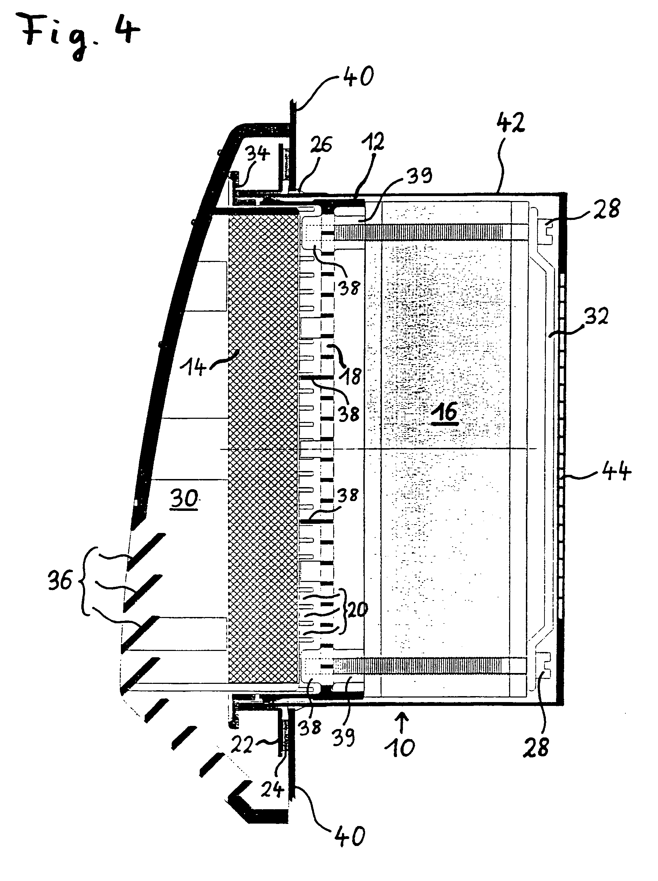

Bei einer zweiten Ausführungsform des erfindungsgemäßen Filterlüfters ist vorgesehen, daß der Einbaurahmen 12 topfförmig ausgebildet ist. In Fig. 4 ist eine entsprechende Längsschnittansicht dieser Ausführungsform dargestellt. Diese alternative Ausführungsform gemäß Fig. 4 unterscheidet sich von der zuvor gezeigten Ausführungsform gemäß Fig. 3 lediglich dadurch, daß ein Topfbereich 42 des topfförmigen Einbaurahmens 10 den Lüftermotor 16 umschließt. Der Topfbereich 42 weist an der der Abdeckhaube 30 gegenüberliegenden Seite einen luftdurchlässigen Bereich 44 auf, der vorzugsweise ebenfalls als Gitter ausgebildet ist. Ist der Einbaurahmen 10 samt dem Topfbereich 42 aus Metall hergestellt oder zumindest mit einer metallenen Oberfläche ausgebildet, wird dadurch eine weitere EMV-Abschirmung bereitgestellt. Bei dieser Ausführungsform kommt eine zusätzliche EMV-Abschirmung zwischen dem Lüftermotor 16 und dem Innenraum des Schaltschrankes hinzu. Dies kann bei bestimmten Anwendungen erforderlich oder gewünscht sein. In jedem Fall wird durch diese Maßnahme die gesamte EMV-Dichtigkeit des Filterlüfters erhöht. Das Schutzgitter 32 ist bei dieser Ausführungsform nicht unbedingt erforderlich.

Weiterhin läßt sich auf einfache Weise ein Austrittsfilter bereitstellen. Der Austrittsfilter enthält alle Bestandteile des Filterlüfters mit Ausnahme des Lüftermotors 16, des Schutzgitters 32 und der Schrauben 28. Weitere Bestandteile sind nicht erforderlich. Dieses Konzept ist herstellungstechnisch besonders günstig, da der Austrittsfilter ausschließlich Teile des Filterlüfters aufweist. Der Austrittsfilter enthält sämtliche Bauteile, die eine Erhöhung der EMV-Dichtigkeit beim Filterlüfter bewirken. Da sowohl der Filterlüfter als auch der Austrittsfilter die gleiche Abdeckhaube 30 aufweisen, ist dies für die ästhetische Ausgestaltung des Schaltschrankes besonders vorteilhaft. Der Austrittsfilter ist auf einfache Weise mit dem Lüftermotor 16 nachrüstbar, so daß er danach als Filterlüfter verwendbar ist.

Sowohl der Filterlüfter als auch der Austrittsfilter gemäß der Erfindung können eine trichterförmige Abdeckhaube aufweisen. Der Filter 14 ist dabei im breiteren Bereich der Abdeckhaube vorgesehen und auf der dem Lüftermotor 16 gegenüberliegenden Seite der Wand angeordnet. Dadurch kann ein größerer Filter verwendet werden, der mehr Staubpartikel aufnehmen kann und somit über einen längeren Zeitraum funktionsfähig ist.

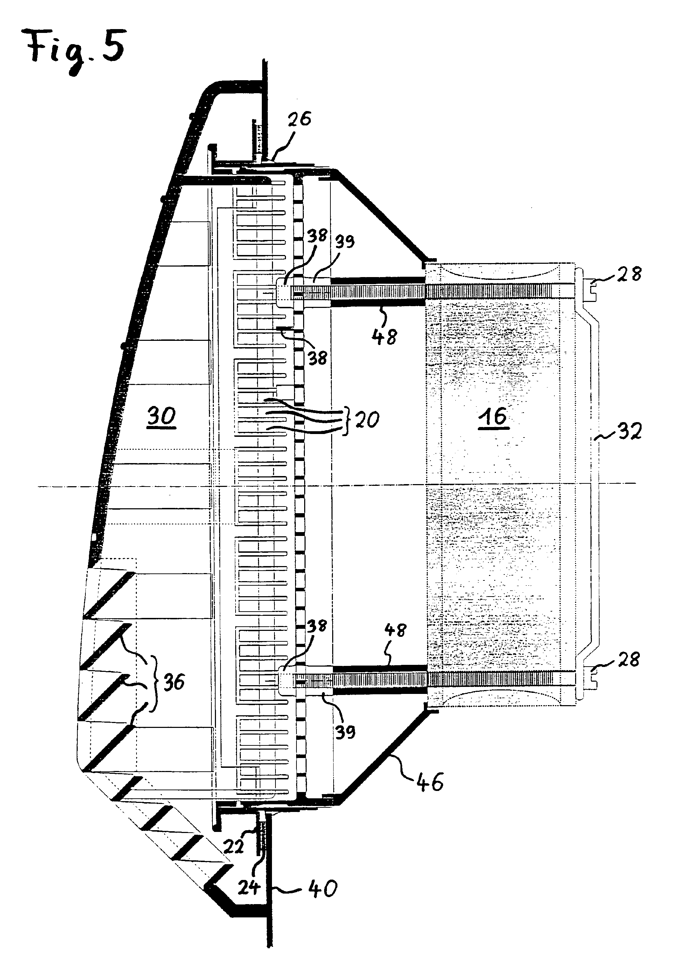

In Figur 5 ist eine dritte Ausführungsform des erfindungsgemäßen Filterlüfters dargestellt, bei der der Einsetzrahmen 12 trichterförmig ausgebildet ist. Ansonsten ist diese Ausführungsform ebenso wie diejenige gemäß Fig. 3 ausgebildet, wobei gleiche Bauteile die gleichen Bezugszeichen haben. Die Ausführungsform gemäß Fig. 5 weist zusätzlich einen Adapter 46 auf, der sich zwischen dem Einsetzrahmen 12 und dem Lüftermotor 16 befindet. Der Adapter 46 ist trichterförmig ausgebildet, wobei dessen größere Öffnung an den Einsetzrahmen 12 und dessen kleinere Öffnung an den Lüftermotor 16 angepaßt sind. Der Adapter 46 ist aus Spritzguß-Kunststoff hergestellt und metallisiert. Die beiden Öffnungen des Adapters 46 weisen Vorsprünge auf, die sich um den Umfang der Öffnungen erstrecken, so daß der Adapter 46 mit dem Einsetzrahmen 12 und dem Lüftermotor 16 passend zusammensetzbar ist. Weiterhin ist jeder Schraube 28 ein Distanzrohr 48 zugeordnet. Die Länge der Distanzrohre 48 entspricht dabei der Tiefe des Adapters 46. Die Distanzrohre 48 sind jeweils zwischen einem Distanzelement 39 und dem Lüftermotor 16 eingespannt, wobei jede Schraube 28 jeweils ein Distanzrohr 48 durchdringt. Der Einsetzrahmen 12, der Adapter 46 und der Lüftermotor 16 sind somit ebenfalls EMV-dicht zusammensetzbar. Auch diese Ausführungsform ermöglicht die Verwendung eines Filters, dessen Querschnittfläche wesentlich größer als die des Lüftermotors 16 ist. In diesem Fall sind der Einbaurahmen 10, der Einsetzrahmen 12, die Abdeckhaube 30 und die Öffnung in der Wand 40 gegenüber dem Lüftermotor 16 entsprechend größer ausgebildet. Der darin verwendete Filter kann mehr Staubpartikel aufnehmen und ist über einen längeren Zeitraum funktionsfähig.

Schließlich können sowohl der Filterlüfter als auch der Austrittsfilter als eine Version ausgebildet sein, die nicht EMV-dicht ist. In diesem Fall ist das Kontaktband 26 mit Zähnen nicht erforderlich. Ein Einsetzrahmen 12 aus Spritzguß-Kunststoff, der nicht metallisiert ist, reicht dazu aus. Auf diese Weise lassen sich besonders kostengünstige Filterlüfter und Austrittsfilter herstellen, falls die EMV-Dichtigkeit nicht erforderlich ist.

Außerdem besteht die Möglichkeit, daß das Gitter 18 direkt am Einbaurahmen 10 angebracht ist. Der Einsetzrahmen 12 ist bei dieser alternativen Möglichkeit nicht vorgesehen. Anstelle der Klebestreifen 26 sind in diesem Fall lösbare Befestigungsmittel für den Einbaurahmen 10 vorgesehen. Diese Ausführungsform ist eine besonders kostengünstige Alternative mit geringem konstruktiven Aufwand.

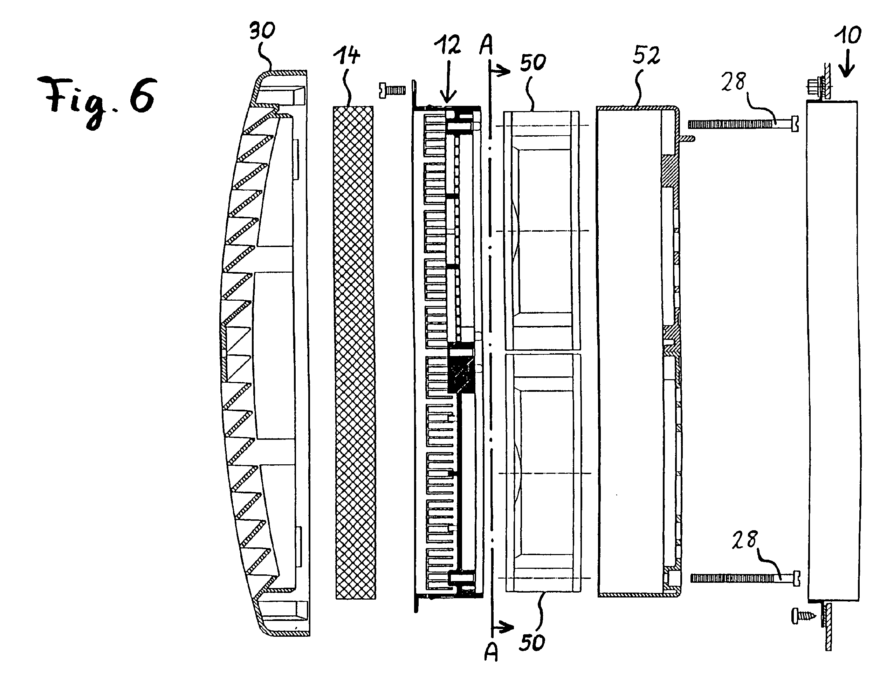

Fig. 6 zeigt eine vierte Ausführungsform des erfindungsgemäßen Filterlüfters. Ebenso wie die bevorzugte Ausführungsform weist die vierte Ausführungsform den Einbaurahmen 10, den Einsetzrahmen 12, den Filter 14 und die Abdeckhaube 30 auf. Der Einbaurahmen 10 und der Einsetzrahmen 12 sind ebenso ausgebildet wie bei der Ausführungsform gemäß Fig. 2. Die vierte Ausführungsform gemäß Fig. 6 zeichnet sich dadurch aus, daß sie anstelle eines einzigen Lüftermotors vier matrixförmig angeordnete Lüftermotoren 50 aufweist. Jeder der Lüftermotoren (50) weist Gebläseflügel auf. Anstelle des Schutzgitters 32 weist diese Ausführungsform ein topfförmig ausgebildetes Aufnahmegitter 52 auf. Dieses Aufnahmegitter 52 ist einerseits als Schutzgitter und andererseits zum Einsetzen der Lüftermotoren 50 vorgesehen. Das Aufnahmegitter 52 ist so dimensioniert, daß eine Mehrzahl von Lüftermotoren 50 im wesentlichen formschlüssig eingesetzt werden kann. Ebenso wie das Schutzgitter 32 ist auch das Aufnahmegitter 52 mittels Schrauben 28 am Einsetzrahmen 12 befestigbar. Dabei durchdringt jede der vier Schrauben 28 jeweils einen der vier Lüftermotoren 50.

Durch die Verwendung mehrerer Lüftermotoren 50 kann dieser Filterlüfter besonders flach ausgebildet sein. Außerdem läßt sich dieser Filterlüfter mit einer verhältnismäßig großen Querschnittsfläche ausbilden. Folglich lassen sich auch entsprechend große Filter 14 verwenden, die verhältnismäßig viel Staub aufnehmen können. Die Häufigkeit des Filterwechselns wird dadurch reduziert. Ein weiterer Vorteil dieser Ausführungsform ist, daß bei Ausfall eines Lüftermotors 50 der Filterlüfter dennoch funktionsfähig bleibt.

Die Ausführungsform mit mehreren Lüftermotoren 50 ist nicht auf vier matrixförmig angeordnete Lüftermotoren 50 beschränkt. Auch eine höhere Anzahl von Lüftermotoren ist möglich. Beispielsweise sind Filterlüfter mit 2x3, 3x3, 2x4, usw. Lüftermotoren 50 denkbar, wenn dies für die Anwendung zweckmäßig ist. Beispielsweise läßt sich mit mehreren Lüftermotoren in einer großen Ausnehmung einer Wand ein besonders flacher Filterlüfter ausbilden.

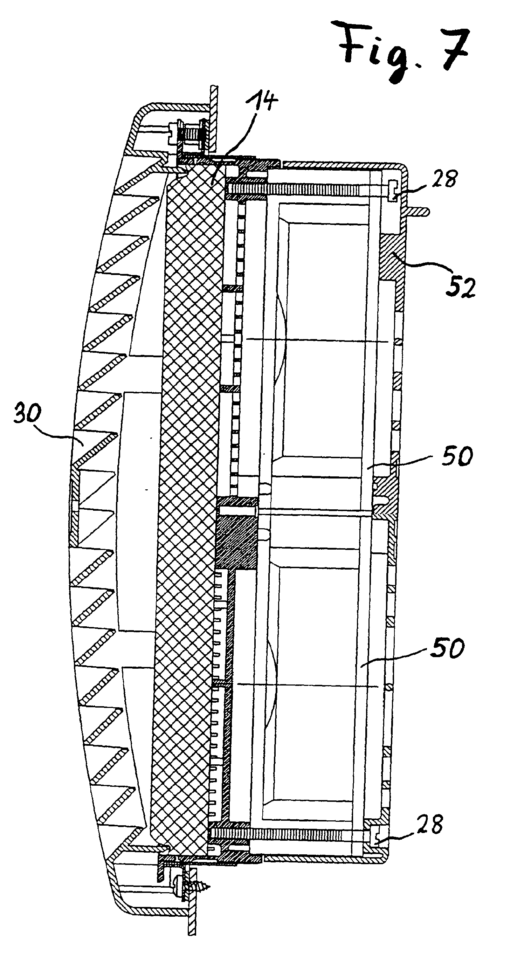

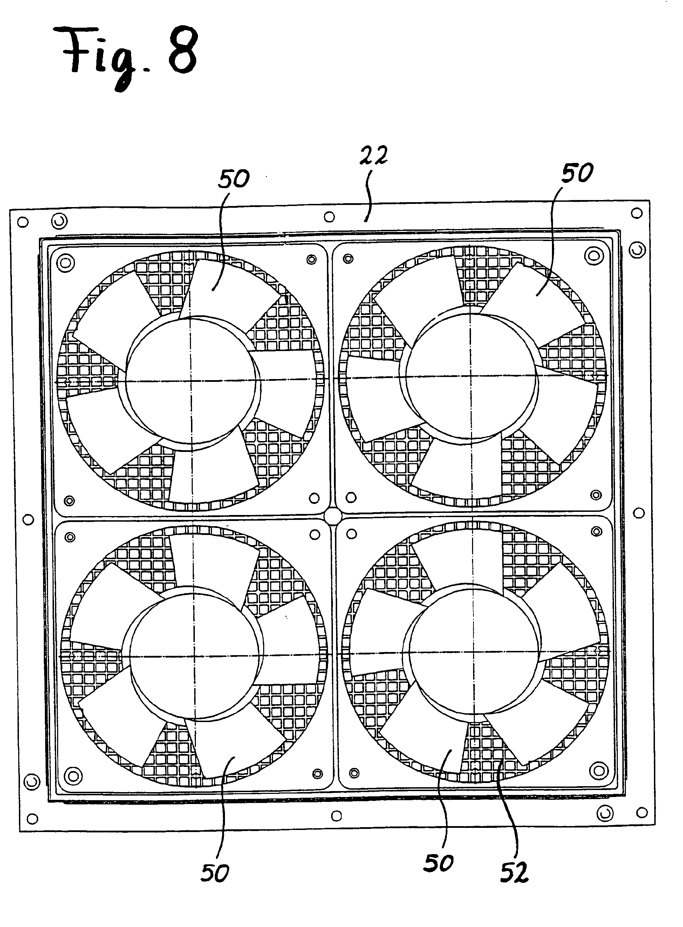

Der Filterlüfter gemäß Fig. 6 ist in Fig. 7 in zusammengesetzter Form dargestellt. Fig. 8 zeigt eine Querschnittansicht, die die Anordnung der Lüftermotoren 50 innerhalb des Aufnahmegitters 52 und des Einbaurahmens 10 verdeutlicht.

### Bezugszeichenliste

- 10: Einbaurahmen
- 12: Einsetzrahmen
- 14: Filter
- 16: Lüftermotor
- 18: Gitter
- 20: Federzungen
- 22: Flansch
- 24: Klebestreifen
- 26: Kontaktband
- 28: Schrauben
- 30: Abdeckhaube
- 32: Schutzgitter
- 34: Flansch
- 36: Lamellen
- 38: Distanzelement
- 39: Distanzelement
- 40: Wand
- 42: Topfbereich
- 44: Gitter
- 46: Adapter
- 48: Distanzrohr
- 50: Lüftermotoren
- 52: Aufnahmegitter

## Patentansprüche

1. Filterlüfter, der in eine Ausnehmung einer Wand (40), insbesondere der Wand (40) eines Schaltschranks, eines Schaltungsgehäuses oder eines Gerätegehäuses montierbar ist und folgendes aufweist:
- einen Lüftermotor (16) mit Gebläseflügeln,
- einen Filter (14), der dem Lüftermotor (16) im Luftstrom vorgeschaltet ist,
- einen Einbaurahmen (10), der mit Befestigungsmitteln (24) in der Ausnehmung dauerhaft befestigbar ist, und
- einen Einsetzrahmen (12), der im Einbaurahmen (10) lösbar eingesetzt ist, wobei der Filter (14) im Einsetzrahmen (12) lösbar eingesetzt ist,
**dadurch gekennzeichnet,**
**dass** der Lüftermotor (16) mit dem Einsetzrahmen (12) derart lösbar verbunden ist, dass der Einsetzrahmen (12) zusammen mit dem Lüftermotor (16) aus dem in der Wand (40) des Schaltschrankes befestigten Einbaurahmen (10) herausnehmbar ist.

2. Filterlüfter nach Anspruch 1,
**dadurch gekennzeichnet, daß**
sich im Einsetzrahmen (12) parallel zur Rahmenebene ein Gitter (18) erstreckt, das zwischen dem Lüftermotor (16) und dem Filter (14) angeordnet ist.

3. Filterlüfter nach Anspruch 2,
**dadurch gekennzeichnet, daß**
der Einsetzrahmen (12) mit dem Gitter (18) einstückig ausgebildet ist.

4. Filterlüfter nach Anspruch 2 oder 3,
**dadurch gekennzeichnet, daß**
der Einsetzrahmen (12) erste Distanzelemente (38) aufweist, so daß ein vorbestimmter Abstand zwischen dem Gitter (18) und dem Filter (14) ausgebildet ist.

5. Filterlüfter nach einem der Ansprüche 2 bis 4,
**dadurch gekennzeichnet, daß**
der Einsetzrahmen (12) zweite Distanzelemente (39) aufweist, so daß ein vorbestimmter Abstand zwischen dem Gitter (18) und dem Lüftermotor (16) ausgebildet ist.

6. Filterlüfter nach einem der Ansprüche 2 bis 5,
**dadurch gekennzeichnet, daß**
der Einbaurahmen (10), der Einsetzrahmen (12) und das Gitter (18) aus Metall hergestellt sind oder zumindest deren Oberflächen eine Metallbeschichtung aufweisen.

7. Filterlüfter nach einem der Ansprüche 1 bis 6,
**dadurch gekennzeichnet, daß**
der Einsetzrahmen (12) im Einbaurahmen (10) mittels einer Klemmvorrichtung lösbar befestigt ist.

8. Filterlüfter nach Anspruch 7,
**dadurch gekennzeichnet, daß**
die Klemmvorrichtung durch eine Vielzahl von Federzungen (20) gebildet ist.

9. Filterlüfter nach Anspruch 8,
**dadurch gekennzeichnet, daß**
die Federzungen (20) am Umfang des Einsetzrahmens (12) angeordnet sind und sich senkrecht zur Rahmenebene erstrekken.

10. Filterlüfter nach einem der Ansprüche 1 bis 9,
**dadurch gekennzeichnet, daß**
der Einbaurahmen (10) einen Flansch (22) aufweist, an dem die Befestigungsmittel (24) angebracht sind.

11. Filterlüfter nach Anspruch 10,
**dadurch gekennzeichnet, daß**
die Befestigungsmittel Klebestreifen (24) sind.

12. Filterlüfter nach einem der Ansprüche 1 bis 11,
**dadurch gekennzeichnet, daß**
der Einbaurahmen (10) ein Kontaktband (26) mit Zähnen umfaßt, das sich entlang des Umfangs des Einbaurahmens (10) erstreckt, so daß die Zähne mit dem Rand der Ausnehmung in Eingriff bringbar sind.

13. Filterlüfter nach einem der Ansprüche 1 bis 12,
**dadurch gekennzeichnet, daß**
der Lüftermotor (16) mittels Schrauben (28) am Einsetzrahmen (12) befestigt ist.

14. Filterlüfter nach Anspruch 13,
**dadurch gekennzeichnet, daß**
der Lüftermotor (16) mittels selbstschneidender Schrauben (28) am Einsetzrahmen (12) befestigt ist, wobei die durch die Schrauben (28) geschnittenen Innengewinde am Einsetzrahmen (12) ausgebildet sind.

15. Filterlüfter nach einem der Ansprüche 1 bis 14,
**dadurch gekennzeichnet, daß**
der Einsetzrahmen (12) aus Spritzguß-Kunststoff hergestellt ist.

16. Filterlüfter nach einem der Ansprüche 1 bis 15,
**gekennzeichnet durch**
eine Abdeckhaube (30), die am Einsetzrahmen (12) lösbar befestigt ist, wobei der Filter (14) zwischen Einsetzrahmen (12) und Abdeckhaube (30) angeordnet ist und die Abdeckhaube (30) einen luftdurchlässigen Bereich aufweist.

17. Filterlüfter nach Anspruch 16,
**dadurch gekennzeichnet, daß**
der luftdurchlässige Bereich der Abdeckhaube (30) eine Mehrzahl Lamellen (36) aufweist, die derart ausgerichtet sind, daß die angesaugte Luft durch den luftdurchlässigen Bereich in Aufwärtsrichtung strömt.

18. Filterlüfter nach einem der Ansprüche 1 bis 17,
**dadurch gekennzeichnet, daß**
der Einbaurahmen (10) topfförmig ausgebildet ist und der Topfbereich (42) den Lüftermotor (16) umschließt und wenigstens einen luftdurchlässigen Bereich aufweist.

19. Filterlüfter nach Anspruch 18,
**dadurch gekennzeichnet, daß**
der luftdurchlässige Bereich durch ein weiteres Gitter (44) gegebildet ist.

20. Filterlüfter nach einem der Ansprüche 1 bis 19,
**dadurch gekennzeichnet, daß**
der Lüftermotor (16) durch eine Vielzahl von Lüftermotoren (50) gebildet ist.

21. Filterlüfter nach Anspruch 20,
**dadurch gekennzeichnet, daß**
die Vielzahl der Lüftermotoren (50) matrixförmig angeordnet ist, und die Luftströme der Lüftermotoren (50) parallel zueinander liegen.

22. Filterlüfter nach Anspruch 20 oder 21,
**dadurch gekennzeichnet, daß**
der Filterlüfter ein Aufnahmegitter (52) aufweist, das zur Aufnahme der Vielzahl der Lüftermotoren (50) vorgesehen ist.

23. Filterlüfter nach einem der Anspüche 1 bis 22,
**dadurch gekennzeichnet, daß**
die Vielzahl der Lüftermotoren (50) eine Vielzahl von Axiallüftern ist.

24. Austrittsfilter, der in eine Ausnehmung einer Wand, insbesondere der Wand eines Schaltschranks, Schaltungsgehäuses, Gerätegehäuses oder dergleichen montierbar ist,
**dadurch gekennzeichnet, daß**
der Austrittsfilter ebenso wie der Filterlüfter nach einem der Ansprüche 1 bis 19 ausgebildet ist, jedoch keinen Lüftermotor (16) und kein Schutzgitter (32) sowie keine Befestigungsmittel (28) für den Lüftermotor (16) und das Schutzgitter (32) aufweist.

## Claims

1. Filter ventilator, which can be mounted in an aperture of a wall (40), in particular the wall (40) of a switch cabinet, circuit box or device housing and which comprises the following:
- a ventilator motor (16) with fan blades,
- a filter (14), which is positioned ahead of the ventilator motor (16) in the airstream, ,
- a build-in frame (10), which is permanently fixed in the aperture by attachment means (24), and
- an insertion frame (12), which is removably inserted in the build-in frame (10) , wherein the filter (14) is removably set in the insertion frame (12),
**characterised in that**
the ventilator motor (16) is releasably connected to the insertion frame (12) in such a way that the insertion frame (12), together with the ventilator motor (16), can be removed from the build-in frame (10) fixed in the wall (40) of the switch cabinet.

2. Filter ventilator according to Claim 1,
**characterised in that**
a grid (18) arranged between the ventilator motor (16) and the filter (14) extends in the insertion frame (12) parallel to the plane of the frame.

3. Filter ventilator according to Claim 2
**characterised in that**
the insertion frame (12) is integrally formed with the grid (18).

4. Filter ventilator according to Claim 2 or 3,
**characterised in that**
the insertion frame (12) has first spacer elements (38), so that a predetermined distance is formed between the grid (18) and the filter (14).

5. Filter ventilator according to one of the Claims 2 to 4,
**characterised in that**
the insertion frame (12) has second spacer elements (39), so that a predetermined distance is formed between the grid (18) and the ventilator motor (16).

6. Filter ventilator according to one of the Claims 2 to 5,
**characterised in that**
the build-in frame (10), the insertion frame (12) and the grid (18) are made of metal or at least their surfaces have a metal coating.

7. Filter ventilator according to one of the Claims 1 to 6,
**characterised in that**
the insertion frame (12) is removably inserted in the build-in frame (10) by means of a clamping device.

8. Filter ventilator according to Claim 7,
**characterised in that**
the clamping device is formed by a plurality of flexible tongues (20).

9. Filter ventilator according to Claim 8,
**characterised in that**
the flexible tongues (20) are arranged around the periphery of the insertion frame (12) and extend perpendicular to the plane of the frame.

10. Filter ventilator according to one of the Claims 1 to 9,
**characterised in that**
the build-in frame (10) has a flange (22), on which the attachment means (24) are accommodated.

11. Filter ventilator according to Claim 10,
**characterised in that**
the attachment means are adhesive strips (24).

12. Filter ventilator according to one of the Claims 1 to 11,
**characterised in that**
the build-in frame (10) comprises a contact band (26) provided with teeth, which extends along the periphery of the build-in frame (10) allowing the teeth to mesh with the edge of the aperture.

13. Filter ventilator according to one of the Claims 1 to 12,
**characterised in that**
the ventilator motor (16) is attached to the insertion frame (12) by means of screws (28).

14. Filter ventilator according to Claim 13,
**characterised in that**
the ventilator motor (16) is attached to the insertion frame (12) by means of self-tapping screws (28), wherein the female threads cut by the screws (28) are formed on the insertion frame (12).

15. Filter ventilator according to one of the Claims 1 to 14,
**characterised in that**
the insertion frame (12) is made of injection-moulded plastics.

16. Filter ventilator according to one of the Claims 1 to 15,
**characterised by**
a covering cap (30), which is releasably attached to the insertion frame(12), wherein the filter (14) is arranged between the insertion frame (12) and covering cap (30) and the coverings cap (30) has an area that is permeable to air.

17. Filter ventilator according to Claim 16,
**characterised in that**
the air-permeable area of the covering cap (30) has a plurality of lamellae (36), which are aligned in such a way that the air drawn in through the air-permeable area flows in an upwards direction.

18. Filter ventilator according to one of the Claims 1 to 17,
**characterised in that**
the build-in frame (10) is constructed in the shape of a cup and the cup-shaped portion(42) encloses the ventilator motor (16) and has at least one area that is permeable to air.

19. Filter ventilator according to Claim 18,
**characterised in that**
the air-permeable area is formed by a further grid (44).

20. Filter ventilator according to one of the Claims 1 to 19,
**characterised in that**
the ventilator motor (16) is formed by a plurality of ventilator motors (50).

21. Filter ventilator according to Claim 20,
**characterised in that**
the plurality of ventilator motors (50) is arranged in the shape of a matrix and the air flows from the ventilator motors (50) are parallel to each other.

22. Filter ventilator according to Claim 20 or 21,
**characterised in that**
the filter ventilator has a retaining grille (52), which is provided to accommodate the
plurality of ventilator motors (50).

23. Filter ventilator according to one of the Claims 1 to 22,
**characterised in that**
the plurality of ventilator motors (50) is a plurality of axial ventilators.

24. Exhaust ventilator, which can be mounted in an aperture of a wall, in particular the wall of a switch cabinet, circuit box, device housing or the like,
**characterised in that**
the exhaust filter is constructed as the filter ventilator according to one of the Claims 1 to 19, but does not have a ventilator motor (16) and a protective grille (32) as well as any attachment means (28) for the ventilator motor (16) and the protective grille (32).

## Revendications

1. Aérateur à filtre, qui est apte à être monté dans un évidement d'une paroi (40), en particulier la paroi (40) d'une armoire électrique, d'un caisson de commande ou d'un carter d'appareil, et comporte les éléments suivants :
- un moteur de ventilateur (16) avec des ailettes de ventilateur,
- un filtre (14), qui est monté dans le flux d'air en amont du moteur de ventilateur (16),
- un cadre d'encastrement (10), qui est destiné à être fixé durablement dans l'évidement avec des moyens de fixation (24), et
- un cadre de montage (12), qui est inséré de manière amovible dans le cadre d'encastrement (10), le filtre (14) étant inséré de manière amovible dans le cadre de montage (12),
**caractérisé en ce que** le moteur de ventilateur (16) est assemblé de manière amovible avec le cadre de montage (12), de telle sorte que le cadre de montage (12) peut être retiré conjointement avec le moteur de ventilateur (16) hors du cadre d'encastrement (10) fixé dans la paroi (40) de l'armoire électrique.

2. Aérateur à filtre selon la revendication 1, **caractérisé en ce que** dans le cadre de montage (12) est disposée une grille (18), qui est parallèle au plan du cadre et qui est agencée entre le moteur de ventilateur (16) et le filtre (14).

3. Aérateur à filtre selon la revendication 2, **caractérisé en ce que** le cadre de montage (12) est réalisé d'un seul tenant avec la grille (18).

4. Aérateur à filtre selon la revendication 2 ou 3, **caractérisé en ce que** le cadre de montage (12) comporte des premiers écarteurs (38), de telle sorte qu'il se forme une distance prédéterminée entre la grille (18) et le filtre (14).

5. Aérateur à filtre selon l'une quelconque des revendications 2 à 4, **caractérisé en ce que** le cadre de montage (12) comporte des deuxièmes écarteurs (39), de telle sorte qu'il se forme une distance prédéterminée entre la grille (18) et le moteur de ventilateur (16).

6. Aérateur à filtre selon l'une quelconque des revendications 2 à 5, **caractérisé en ce que** le cadre d'encastrement (10), le cadre de montage (12) et la grille (18) sont réalisés en métal ou au moins la surface de ceux-ci comporte un revêtement métallique.

7. Aérateur à filtre selon l'une quelconque des revendications 1 à 6, **caractérisé en ce que** le cadre de montage (12) est fixé de manière amovible dans le cadre d'encastrement (10) au moyen d'un dispositif de serrage.

8. Aérateur à filtre selon la revendication 7, **caractérisé en ce que** le dispositif de serrage est formé par une pluralité de languettes flexibles (20).

9. Aérateur à filtre selon la revendication 8, **caractérisé en ce que** les languettes flexibles (20) sont agencées sur le pourtour du cadre de montage (12) et sont orientées perpendiculairement au plan du cadre.

10. Aérateur à filtre selon l'une quelconque des revendications 1 à 9, **caractérisé en ce que** le cadre d'encastrement (10) comporte une bride (22) sur laquelle sont montés les moyens de fixation (24).

11. Aérateur à filtre selon la revendication 10, **caractérisé en ce que** les moyens de fixation sont des rubans adhésifs (24).

12. Aérateur à filtre selon l'une quelconque des revendications 1 à 11, **caractérisé en ce que** le cadre d'encastrement (10) comporte une bande de contact (26) avec des dents, qui s'étend le long du pourtour du cadre d'encastrement (10), de telle sorte que les dents peuvent être amenées en prise avec le bord de l'évidement.

13. Aérateur à filtre selon l'une quelconque des revendications 1 à 12, **caractérisé en ce que** le moteur de ventilateur (16) est fixé au moyen de vis (28) sur le cadre de montage (12).

14. Aérateur à filtre selon la revendication 13, **caractérisé en ce que** le moteur de ventilateur (16) est fixé au moyen de vis (28) autoraudeuses sur le cadre de montage (12), les taraudages taillés par les vis (28) étant réalisés sur le cadre de montage (12).

15. Aérateur à filtre selon l'une quelconque des revendications 1 à 14, **caractérisé en ce que** le cadre de montage (12) est réalisé en matière plastique moulée par injection.

16. Aérateur à filtre selon l'une quelconque des revendications 1 à 15, **caractérisé par** un cache (30), qui est fixé de manière amovible sur le cadre de montage (12), le filtre (14) étant monté entre le cadre de montage (12) et le cache (30), et le cache (30) comportant une zone laissant passer l'air.

17. Aérateur à filtre selon la revendication 16, **caractérisé en ce que** la zone laissant passer l'air dans le cache (30) comporte une pluralité de lamelles (36), qui sont orientées de telle sorte que l'air aspiré afflue dans le sens ascendant à travers la zone laissant passer l'air.

18. Aérateur à filtre selon l'une quelconque des revendications 1 à 17, **caractérisé en ce que** le cadre d'encastrement (10) est réalisé en forme de corps creux et le corps (42) entoure le moteur de ventilateur (16) et comporte au moins une zone laissant passer l'air.

19. Aérateur à filtre selon la revendication 18, **caractérisé en ce que** la zone laissant passer l'air est formée par une autre grille (44).

20. Aérateur à filtre selon l'une quelconque des revendications 1 à 19, **caractérisé en ce que** le moteur de ventilateur (16) est formé par une pluralité de moteurs de ventilateur (50).

21. Aérateur à filtre selon la revendication 20, **caractérisé en ce que** la pluralité de moteurs de ventilateur (50) est agencée en forme de matrice, et les flux d'air des moteurs de ventilateur (50) sont parallèles entre eux.

22. Aérateur à filtre selon la revendication 20 ou 21, **caractérisé en ce que** l'aérateur à filtre comporte une grille de réception (52), qui est prévue pour recevoir la pluralité de moteurs de ventilateur (50).

23. Aérateur à filtre selon l'une quelconque des revendications 1 à 22, **caractérisé en ce que** la pluralité de moteurs de ventilateur (50) est une pluralité de ventilateurs axiaux.

24. Filtre d'évacuation, qui est destiné à être monté dans un évidement d'une paroi, en particulier la paroi d'une armoire électrique, d'un caisson de commande ou d'un carter d'appareil ou similaire,
**caractérisé en ce que** le filtre d'évacuation, tout comme l'aérateur à filtre, est réalisé selon l'une quelconque des revendications 1 à 19, mais ne comporte ni moteur de ventilateur (16), ni grille de protection (32) et ni moyens de fixation (28) pour le moteur de ventilateur (16) et la grille de protection (32).
